# EUROPÄISCHE PATENTSCHRIFT

(11) **EP 2 619 599 B1**
(45) Veröffentlichungstag und Bekanntmachung des Hinweises auf die Patenterteilung: **27.08.2014**
(21) Anmeldenummer: 10779545.2
(22) Anmeldetag: 17.11.2010
(51) Int. Cl.: G01R 19/165, G01R 29/18, H02K 11/00

(54) **ELEKTRISCHES GERÄT UND VERFAHREN ZUR ERMITTLUNG EINES PHASENAUSFALLS IN DEM ELEKTRISCHEN GERÄT**
ELECTRICAL DEVICE AND METHOD FOR DETECTING A PHASE LOSS IN AN ELECTRICAL DEVICE
DISPOSITIF ELECTRIQUE ET PROCEDE DE DETECTION D'UNE PERTE DE PHASE DANS UN DISPOSITIF ELECTRIQUE

(43) Veröffentlichungstag der Anmeldung: 31.07.2013
(73) Patentinhaber: Siemens Aktiengesellschaft, 80333 München (DE)
(72) Erfinder: HERTZ, Dirk, 92260 Fichtenhof (DE); SCHÖNENBERG, Marco, 92245 Kümmersbruck (DE); SEITZ, Johann, 92224 Amberg (DE); ZITZLER, Stefan, 92421 Schwandorf (DE)
(86) Internationale Anmeldenummer: PCT/EP2010/067638
(87) Internationale Veröffentlichungsnummer: WO 2012/065633

(56) Entgegenhaltungen:
- EP-A2- 1 107 010
- DE-A1-102005 016 720

## Beschreibung

Die Erfindung betrifft eine Verfahren zur Ermittlung eines Phasenausfalls in einem elektrischen Gerät sowie ein elektrisches Gerät, mit welchem ein Phasenausfall in dem elektrischen Gerät ermittelt werden kann.

Im Bereich der industriellen Automatisierungstechnik werden zum Ansteuern oder Überwachen eines dreiphasigen Drehstrommotors elektrische Geräte, wie beispielsweise Sanftanlaufgeräte, Überlastrelais oder Motorstarter, eingesetzt.

Bei elektrischen Sanftanlaufgeräten, für Drehstrommotoren werden neben 3-phasig gesteuerten Sanftanlaufgeräten (Drehstromsteller) auch 2-phasig gesteuerte Sanftanlaufgeräte eingesetzt. Bei den 3-phasig gesteuerten Sanftanlaufgeräten sind meist drei Stromwandler zur Steuerung und Messung des Stroms in den drei Leitungen (Phasen) des Sanftanlaufgerätes vorhanden. Bei 2-phasig gesteuerten Sanftanlaufgeräten ist eine der drei Leitungen (Phasen) des Sanftanlaufgerätes gebrückt und es kann prinzipiell auf einen Stromwandler (in der gebrückten Leitung) verzichtet werden, um den Sanftanlauf des Motors durchzuführen. Über die drei Leitungen des Sanftanlaufgerätes wird die Energieversorgung des mit dem Sanftanlaufgerät verbundenen Drehstrommotors geführt und gesteuert, so dass beispielsweise ein definiertes Anlaufverhalten des Drehstrommotors herbeigeführt werden kann.

Die Strommesssignale der Stromwandler des Sanftanlaufgerätes können unter Anderem auch zur Erkennung eines Phasenausfalls genutzt werden. Hier ist es jedoch problematisch, wenn in einer Leitung (Phase) des Stromwandlers kein Stromwandler vorhanden ist. Somit kann ein Phasenausfall in der Leitung, in der kein Stromwandler vorhanden ist, nicht erkannt werden und der Motor würde auf zwei Phasen weiterlaufen bis ihn ein anderer Schutzmechanismus abschalten würde. Bei einem Phasenausfall liegt insbesondere einer Unterbrechung eines zu Übertragenden Stroms innerhalb der Leitung vor.

Eine Phasenausfallerkennung kann auch anhand einer analogen Spannungsmessung durchgeführt werden. Das Fehlen einer Spannung kann relativ leicht erkannt werden, wenn die Spannung in einer Leitung einen festgelegten Schwellwert unterschreitet. Hierfür ist aber die entsprechende Hardware und Firmware notwendig, um diese Erkennung realisieren zu können.

Eine Phasenausfallerkennung anhand des Stromes wurde bisher mit drei Stromwandlern umgesetzt. Sinkt ein Strom einer Leitung unter einen festgelegten Schwellwert, kann davon ausgegangen werden, dass an der Leitung keine Spannung anliegt.

Aus der EP 1 107 010 A2 ist ein Elektrizitätszähler bekannt. Bei diesem Elektrizitätszähler erfolgt eine PhasenausfallÜberwachung mittels einer Analyse zweier erfasster verketteter Spannungen. Hierfür werden zwei Spannungssensoren eingesetzt.

Aus der DE 10 2005 016 720 A1 ist ein selbstversorgendes, spannungsamplitudenunabhängiges Netzüberwachungsgerät zur Diagnose von Phasenausfällen und Phasenamplitudenverminderungen in Mehrphasenversorgungssystemen bekannt.

Es ist Aufgabe der vorliegenden Erfindung in einem dreiphasigen elektrischen Gerät, insbesondere in einem Sanftanlaufgerät, einen Phasenausfall einer Leitung zu erkennen.

Hierbei soll insbesondere lediglich durch eine Analyse zweier Leitungen (Phasen) des elektrischen Gerätes ein Phasenausfall der anderen Leitung (Phase) des elektrischen Gerätes ermittelbar sein.

Diese Aufgabe wird gelöst durch ein Verfahren gemäß Anspruch 1 sowie eine Vorrichtung gemäß Anspruch 8.

Vorteilhafte Weiterbildungen der Erfindung sind in den abhängigen Ansprüchen 2 bis 7 sowie 9 bis 11 angegeben.

Das elektrische Gerät ist vorzugsweise ein Sanftanlaufgerät, ein Überlastrelais oder ein Motorstarter. Über die erste, zweite und dritte Leitung (Phase) des elektrischen Geräts erfolgt die Energieversorgung des mit dem elektrischen Gerät verbundenen Drehstrommotors. Das Verfahren findet insbesondere im Betrieb des Drehstrommotors und somit im Betriebszustand des elektrischen Geräts Anwendung.

Bei dem dreiphasigen elektrischen Gerät, das beispielsweise nur in zwei Phasen (der ersten und zweiten Leitung) über eine Strommessung verfügt, kann anhand einer Analyse der beiden Ströme in den ersten und zweiten Leitungen und insbesondere deren Phasenverschiebung zueinander ein Phasenausfall in der dritten Leitung (Phase) erkannt werden.

Im Normalfall (kein Phasenausfall in einer der Leitungen) liegen alle drei Netzspannungen an und die Ströme in den drei Leitungen sind jeweils um 120° phasenverschoben.

Bei einem Phasenausfall in einer der beiden Leitungen mit vorhandener Strommessung kann der Phasenausfall anhand der Höhe des Stroms und an der Unsymmetrie der beiden Ströme erkannt werden. Fehlt nun die Spannung in der dritten Leitung (Phasenausfall in der dritten Leitung), in der kein Stromwandler vorhanden ist, ist keine Unsymmetrie zu erkennen. Die beiden Ströme sind nun um 180° phasenverschoben. Durch eine Analyse der Phasenverschiebung der Ströme in der ersten und zweiten Leitung kann somit ein Rückschluss auf einen Phasenausfall in der dritten Leitung gezogen werden. Auf diese Weise kann lediglich durch eine Analyse zweier Leitungen des elektrischen Geräts ein Phasenausfall in der anderen Leitung des elektrischen Gerätes ermittelt werden.

Sobald anhand der Analyse zur Phasenverschiebung zwischen der ersten und zweiten Leitung erkannt wird, dass keine ordnungsgemäße Phasenverschiebung vorliegt, sondern eine Phasenverschiebung vorliegt, welche einen Phasenausfall in der dritten Leitung charakterisiert, wird ein Signal ausgegeben, so dass ein übergeordnetes System über den Phasenausfall informiert wird. Vorzugsweise muss der eine Phasenverschiebung charakterisierende Wert, welcher einen Phasenausfall in der dritten Leitung charakterisiert und somit innerhalb des Wertebereichs liegt, über einen bestimmten Zeitraum vorliegen, so dass kurzzeitige Abweichungen, welche nicht über die Dauer des Zeitraums anhalten, nicht zu einer Ausgabe eines Signals, welches einen Phasenausfall anzeigt, führen.

Das elektrische Gerät muss somit zur Phasenüberwachung nicht je Phase einen Sensor zur Überwachung eines Phasenausfalls aufweisen und kann somit kostengünstiger gefertigt sowie kompakter ausgebildet werden.

Bei der Analyse hinsichtlich der Phasenverschiebung zwischen dem Strom in der ersten und zweiten Phase muss nicht die tatsächliche Phasenverschiebung zwischen dem Strom in der ersten und zweiten Leitung ermittelt werden. Es genügt ebenso, wenn ein die Phasenverschiebung charakterisierender Wert ermittelt wird, welcher mit dem Wertebereich verglichen werden kann, so dass eine Auskunft über einen Phasenausfall in der dritten Leitung erfolgen kann. Der Wertebereich bildet folglich einen Bereich hinsichtlich des ermittelten Wertes ab, welcher einen Phasenausfall der dritten Leitung charakterisiert. Der eine Phasenverschiebung zwischen dem Strom in der ersten und zweiten Leitung charakterisierenden Wert gibt insbesondere eine unmittelbare Auskunft über die vorliegende Phasenverschiebung des Stroms der ersten und zweiten Phase wieder. Der charakterisierende Wert gibt vorzugsweise die Phasenverschiebung zwischen dem Strom in der ersten und zweiten Leitung direkt wieder.

In einer vorteilhaften Ausführungsform der Erfindung charakterisiert der Wertebereich eine Phasenverschiebung zwischen der ersten und zweiten Leitung von 150° bis 210°. Liegt folglich eine Phasenverschiebung zwischen der ersten und zweiten Phase von 150° bis 210°, insbesondere 180°, vor, so fällt der ermittelte eine Phasenverschiebung charakterisierende Wert in den Wertebereich, welcher eine Phasenverschiebung in der dritten Leitung charakterisiert. Folglich wird ein Signal ausgegeben, welches einen Phasenausfall in der dritten Leitung anzeigt.

In einer weiteren vorteilhaften Ausführungsform der Erfindung erfolgt die Ermittlung des Phasenausfalls in der dritten Leitung lediglich anhand einer Analyse der ersten und zweiten Leitung. Die dritte Leitung muss somit keinen Sensor zur Ermittlung eines Phasenausfalls umfassen. Kosten können hierdurch eingespart werden.

In einer weiteren vorteilhaften Ausführungsform der Erfindung erfolgt die Ermittlung des eine Phasenverschiebung zwischen dem Strom in der ersten und zweiten Leitung charakterisierenden Wertes durch Messungen zum Zeitpunkt des Nulldurchgangs und/oder Scheitelwertes des Stroms in der ersten und zweiten Leitung. Die Phasenverschiebung bzw. der charakterisierende Wert kann beispielsweise anhand einer zeitlichen Differenz zwischen den Zeitpunkten der Nulldurchgänge oder Scheitelwerte des Strom der ersten Leitung gegenüber des Stroms der zweiten Leitung ermittelt werden. Ebenso kann anhand einer Betrachtung des Stroms zu diesen Zeitpunkten ein Rückschluss auf die Phasenverschiebung gewonnen werden.

In einer weiteren vorteilhaften Ausführungsform der Erfindung erfolgen innerhalb eines Zeitfensters mehrfach das Ermitteln des eine Phasenverschiebung zwischen dem Strom in der ersten und zweiten Leitung charakterisierenden Wertes und ein Vergleich des ermittelten Wertes zu dem Wertebereich. Das vorzugsweise voreingestellte Zeitfenster ist beispielsweise eine Periodendauer des Stroms. Die Ermittlung des eine Phasenverschiebung charakterisierenden Wertes erfolgt somit mehrmals innerhalb der Periode des Stroms der ersten oder zweiten Leitung. Vorzugsweise erfolgt die Ermittlung des Wertes und somit der Phasenverschiebung mindestens 5-mal innerhalb des voreingestellten Zeitfensters. Vorzugsweise erfolgt der Vergleich der jeweiligen ermittelten Werte jeweils mit dem Wertebereich.

In einer weiteren vorteilhaften Ausführungsform der Erfindung wird das Signal erst dann ausgegeben, wenn der ermittelte eine Phasenverschiebung charakterisierende Wert, welche in dem Wertebereich liegt, einen weiteren Parameter erfüllt. Der Parameter kennzeichnet beispielsweise die Häufigkeit der im Wertebereich liegenden übereinstimmenden ermittelten Werte der Phasenverschiebungen gegenüber den Ermittlungen innerhalb eins Zeitraums (z.B. eine Periodendauer des Stroms). Liegt eine ausreichende Häufigkeit vor, so wird das Signal ausgegeben. Ebenso kann der Parameter einen Schwellwert bezüglich der Anzahl der im Wertebereich liegenden übereinstimmenden ermittelten Werte der Phasenverschiebungen darstellen. Liegt eine ausreichende Anzahl an Übereinstimmungen vor, so wird das Signal ausgegeben. Die Analyse hinsichtlich des Parameters erfolgt vorzugsweise wiederholt innerhalb eines definierten Zeitraums. Der Parameter kann ebenso einen Zeitraum definieren, innerhalb welchen jeweils eine Übereinstimmung der wiederholten Ermittlungen der charakterisierenden Werte der Phasenverschiebung im Wertebereich liegen sollen. Es ist ebenso denkbar, dass die Analyse hinsichtlich des Parameters aus einer Kombination mehrerer dieser sowie weiterer Kriterien gebildet wird.

In einer weiteren vorteilhaften Ausführungsform der Erfindung umfasst die Analyse folgende Schritte:
a) Gleichzeitiges ermitteln der Flussrichtung des Stroms in der ersten und zweiten Leitung,
b) Ermitteln einer Anzahl von Differenzen, in welchen sich die unter Schritt a) ermittelte Flussrichtung der ersten Leitung von der gleichzeitig ermittelten Flussrichtung der zweiten Leitung unterscheidet,
c) Ermitteln einer Anzahl der unter Schritt a) erfolgten Ermittlungen,
d) Ausgeben eines Signals, sofern innerhalb eines Zeitfensters das Verhältnis der Anzahl der Differenzen gegenüber der Anzahl der durchgeführten Ermittlungen zwischen 0% bis 10% oder 90% bis 100% liegt.

Unter den Begriff gleichzeitiges ermitteln der Flussrichtung ist ebenso eine Ermittlung mit einem leichten zeitlichen Versatz zu verstehen. Je synchroner die Ermittlung der Flussrichtung in den beiden Leitungen erfolgt, desto genauer erfolgt letztendlich die Analyse im elektrischen Gerät.

Zur Ermittlung der Flussrichtung werden vorzugsweise in der ersten und zweiten Leitung jeweils Stromsensoren verwendet. Sind hierbei die einzelnen Stromsensoren zur Ermittlung der Flussrichtung gleich eingebaut (d.h. in Bezug auf die Flussrichtung der ersten und zweiten Phase wird eine gleiche Orientierung der Flussrichtung betrachtet), so liegt bei einem Phasenausfall eine Abweichung zwischen 90-100% vor. Sind jedoch die beiden Stromsensoren entgegengesetzt eingebaut (d.h. in Bezug auf die Flussrichtung der ersten und zweiten Phase wird eine entgegen gesetzte Orientierung der Flussrichtung betrachtet), so liegt bei einem Phasenausfall eine Abweichung zwischen 0-10% vor.

Liegt eine Phasenverschiebung von 180° und somit ein Phasenausfall in der dritten Leitung vor, so weist die Flussrichtung bis auf den Nulldurchgang eine entgegengesetzte Orientierung auf. Mittels der Analyse der Flussrichtung des Stroms innerhalb der ersten und zweiten Leitung kann ein Rückschluss auf die vorliegende Phasenverschiebung und insbesondere auf einen vorliegenden Phasenausfall in der dritten Leitung gewonnen werden.

In einer weiteren vorteilhaften Ausführungsform der Erfindung umfasst die Analyse folgende Schritte:
a) Gleichzeitiges ermitteln der Flussrichtung des Stroms in der ersten und zweiten Leitung,
b) Ermitteln einer Anzahl von Übereinstimmungen, in welchen die unter Schritt a) ermittelte Flussrichtung der ersten Leitung von der gleichzeitig ermittelten Flussrichtung der zweiten Leitung übereinstimmt,
c) Ermitteln einer Anzahl der unter Schritt a) erfolgten Ermittlungen,
d) Ausgeben eines Signals, sofern innerhalb eines Zeitfensters das Verhältnis der Anzahl der Übereinstimmungen gegenüber der Anzahl der durchgeführten Ermittlungen zwischen 11% bis 89% liegt.

In einer weiteren vorteilhaften Ausführungsform der Erfindung umfasst das elektrische Gerät eine Verarbeitungseinheit und ein Strommessmittel, wobei der Schritt a) mittels des Strommessmittels erfolgt und die Schritte b), c) und d) mittels der Verarbeitungseinheit erfolgen. Das Strommessmittel umfasst vorzugsweise je Phase/Leitung mindestens einen Stromsensor, welcher die Flussrichtung innerhalb der Leitung ermitteln kann. Die Strommessung erfolgt vorzugsweise ebenso durch das Strommessmittel.

In einer weiteren vorteilhaften Ausführungsform der Erfindung wird der Schritt a) mindestens 5-mal innerhalb des Zeitfensters durchgeführt. Vorzugsweise wird bei einer Netzfrequenz von 50 Hz mindestens alle 400 Mikrosekunden der Schritt a) durchgeführt.

In einer weiteren vorteilhaften Ausführungsform der Erfindung wird die unter Schritt b) ermittelte Anzahl sowie die Anzahl der ermittelten unter Schritt a) erfolgten Ermittlungen, vorzugsweise nach Ablauf des Zeitfensters, zurückgesetzt.

In einer weiteren vorteilhaften Ausführungsform der Erfindung umfasst die Verarbeitungseinheit einen ersten und einen zweiten Zähler, wobei mit dem ersten Zähler die unter Schritt b) ermittelte Anzahl und mit dem zweiten Zähler die unter Schritt c) ermittelte Anzahl gezählt wird.

In einer weiteren vorteilhaften Ausführungsform der Erfindung beträgt das Zeitfenster mindestens eine Periodendauer des Stroms in der ersten oder zweiten Leitung. Das Zeitfenster ist vorzugsweise werksseitig voreingestellt. Es dauert somit mindestens eine Periodendauer des Stroms an.

In einer weiteren vorteilhaften Ausführungsform der Erfindung kann das elektrische Gerät lediglich in der ersten und zweiten Leitung eine Strommessung durchführen. Vorzugsweise erfolgen bei dem elektrischen Gerät an den einzelnen Leitungen bis auf die Strommessung bei der ersten und zweiten Leitung keine weiteren Strom- und/oder Spannungsmessungen.

In einer weiteren vorteilhaften Ausführungsform der Erfindung ist mit dem Strommessmittel gleichzeitig die Flussrichtung des Stroms in der ersten und zweiten Leitung ermittelbar und mit der Verarbeitungseinheit:
- eine Anzahl von Differenzen, in welchen sich die durch das Strommessmittel ermittelte Flussrichtung der ersten Leitung von der gleichzeitig ermittelten Flussrichtung der zweiten Leitung unterscheidet, ermittelbar ist,
- eine Anzahl der durch das Strommessmittel erfolgten gleichzeitigen Ermittlungen der Flussrichtung des Stroms in der ersten und zweiten Leitung ermittelbar ist, und
- ein Signal ausgebbar ist, sofern innerhalb eines Zeitfensters das Verhältnis der Anzahl der Differenzen gegenüber der Anzahl der durchgeführten Ermittlungen zwischen 0% bis 10% oder 90% bis 100% liegt.

In einer weiteren vorteilhaften Ausführungsform der Erfindung ist mit dem Strommessmittel gleichzeitig die Flussrichtung des Stroms in der ersten und zweiten Leitung ermittelbar und mit der Verarbeitungseinheit:
- eine Anzahl von Übereinstimmungen, in welchen sich die durch das Strommessmittel ermittelte Flussrichtung der ersten Leitung von der gleichzeitig ermittelten Flussrichtung der zweiten Leitung übereinstimmen, ermittelbar ist,
- eine Anzahl der durch das Strommessmittel erfolgten gleichzeitigen Ermittlungen der Flussrichtung des Stroms in der ersten und zweiten Leitung ermittelbar ist, und
- ein Signal ausgebbar ist, sofern innerhalb eines Zeitfensters das Verhältnis der Anzahl der Übereinstimmungen gegenüber der Anzahl der durchgeführten Ermittlungen zwischen 11% bis 89% liegt.

Die Anzahl der ermittelten Übereinstimmungen bzw. Differenzen sowie die Anzahl der durch das Strommessmittel erfolgten gleichzeitigen Ermittlungen der Flussrichtung des Stroms in der ersten und zweiten Leitung sind vorzugsweise nach Ablauf des Zeitfensters durch die Verarbeitungseinheit zurücksetzbar.

In einer vorteilhaften Ausführungsform der Erfindung umfasst die Verarbeitungseinheit mindestens einen Zähler, mit welchem, die Anzahl der der ermittelten Übereinstimmungen bzw. Differenzen sowie die Anzahl der durch das Strommessmittel erfolgten gleichzeitigen Ermittlungen zählbar sind.

Das Zeitfenster, welches vorzugsweise werkseitig voreingestellt ist, beträgt vorzugsweise mindestens eine Periodendauer des Stroms in der ersten oder zweiten Leitung.

In einer weiteren vorteilhaften Ausführungsform der Erfindung ist das elektrische Gerät ein Sanftanlaufgerät.

Im Folgenden werden die Erfindung und Ausgestaltungen der Erfindung anhand der in den Figuren dargestellten Ausführungsbeispiele näher beschrieben und erläutert. Es zeigen:
- FIG 1: einen schematische Darstellung eines elektrischen Gerätes, welches an einen dreiphasigen Drehstrommotor angeschlossen ist,
- FIG 2: einen schematische Darstellung der Ströme in der ersten und zweiten Leitung, wenn alle drei Spannungen anliegen, und
- FIG 3: einen schematische Darstellung der Ströme in der ersten und zweiten Leitung, wenn ein Phasenausfall in der dritten Leitung vorliegt.

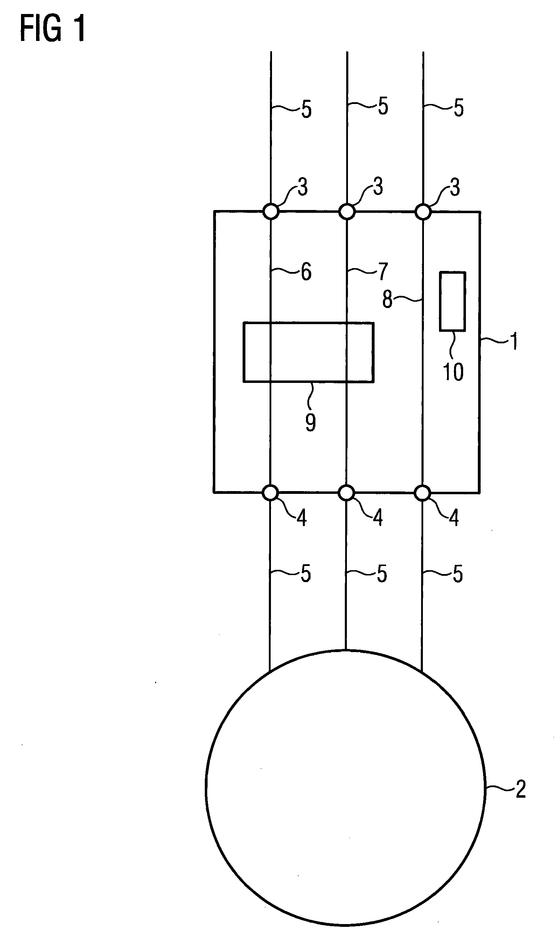

FIG 1 zeigt eine schematische Darstellung eines elektrischen Gerätes 1, welches an einen dreiphasigen Drehstrommotor 2 angeschlossen ist. Über das elektrische Gerät 1 werden drei Phasen des Drehstrommotors 2 mit einem Versorgungsnetzes verbunden, so dass der Drehstrommotor 2 mit Energie versorgt werden kann. Das hier abgebildete elektrische Gerät 1 ist ein Sanftanlaufgerät 1. Das Sanftanlaufgerät 1 weist je Phase eine eingangsseitige Anschlussstelle 3 sowie eine ausgangsseitige Anschlussstelle 4 auf, welche mittels einer internen Leitung 6,7,8 des Sanftanlaufgerätes miteinander elektrisch leitend verbindbar sind.

Über die eingangsseitig angeschlossenen Leitungen 5 wird die für den Drehstrommotor vorgesehne Energie von einem Versorgungsnetz in das Sanftanlaufgerät 1 eingespeist. Über die mit den ausgangsseitigen Anschlussstellen 4 verbundenen externen Leitungen 5 wird dem dreiphasigen Drehstrommotor 2 die Energie zugespielt. Das Sanftanlaufgerät 1 weist folglich drei Phasen auf. Die erste Leitung 6 des Sanftanlaufgerätes 1 spiegelt hierbei die erste Phase des Systems (Sanftanlaufgerät 1 und Drehstrommotor 2) wieder. Die zweite Leitung 7 spiegelt die zweite Phase des Systems wieder. Die dritte Leitung 8 spiegelt die dritte Phase des Systems wieder.

Das Sanftanlaufgerät 1 umfasst ferner ein Strommessmittel 9 sowie eine Verarbeitungseinheit 10. Über das Strommessmittel 9 erfolgt eine Strommessung des Stroms in der ersten und zweiten Leitung 6,7. Bei dem Sanftanlaufgerät 1 steht die dritte Leitung 8 in keiner Wirkverbindung mit einem Stromsensor, so dass der Strom in der dritten Leitung 8 nicht durch das Sanftanlaufgerät 1 gemessen werden kann. Liegt folglich ein Phasenausfall an der dritten Leitung 8 vor, so umfasst die dritte Leitung 8 keinen Stromsensor, welcher einen Phasenausfall detektieren kann. Ferner umfasst das Sanftanlaufgerät 1 keinen Spannungssensor, welcher eine Spannung hinsichtlich der ersten, zweiten und dritten Leitung 6,7,8 ermitteln kann. Das Strommessmittel 9 umfasst einen ersten und zweiten Stromsensor, wobei der erste Stromsensor einen Strom in der ersten Leitung 6 ermitteln kann und der zweite Stromsensor einen Strom in der zweiten Leitung 7 ermitteln kann. Über das Strommessmittel 9 und seine Stromsensoren kann ebenso die Flussrichtung des Stroms in der ersten und zweiten Leitung 6,7 ermittelt werden. Das Strommessmittel 9 ist mit der Verarbeitungseinheit 10 derart verbunden, dass die ermittelten Messwerte des Strommessmittels 9 der Verarbeitungseinheit 10 zuspielbar sind. Die Verarbeitungseinheit 10 kann aus den ermittelten Messwerten des Strommessmittels 9 einen Rückschluss auf die vorliegende Phasenverschiebung des Stromes zwischen der ersten und zweiten Leitung 6,7 bilden. Das Strommessmittel 9 liefert folglich einen eine Phasenverschiebung zwischen dem Strom in der ersten und zweiten Leitung 6,7 charakterisierenden Wert. Die Verarbeitungseinheit 10 kann diesen ermittelten Wert mit einem Wertebereich vergleichen. Dieser Wertebereich charakterisiert einen Phasenausfall in der dritten Leitung 8. Liegt folglich der ermittelte Wert innerhalb dieses Wertebereiches, so liegt ein Phasenausfall in der dritten Leitung 8 vor. Da der ermittelte Wert eine Phasenverschiebung zwischen dem Strom in der ersten und zweiten Leitung 6,7 charakterisiert, erfolgt folglich eine Ermittlung eines Phasenausfalls in der dritten Leitung 8 anhand der Phasenverschiebung zwischen dem Strom in der ersten und zweiten Leitung 6,7.

Im Normalfall (d.h. es liegt kein Phasenausfall vor und an allen drei Phasen 6,7,8 liegt die Netzspannungen an) sind die Ströme in den drei Phasen 6,7,8 jeweils um 120° phasenverschoben. Die Phasenverschiebung zwischen dem Strom in der ersten und zweiten Leitung 6,7 beträgt folglich 120°. Der im Normalbetrieb ermittelte eine Phasenverschiebung zwischen dem Strom in der ersten und zweiten Leitung 6,7 charakterisierende Wert spiegelt folglich eine Phasenverschiebung um die 120° wieder. Ein Vergleich des ermittelten Wertes mit dem Wertebereich würde ergeben, dass der Wert nicht innerhalb des Wertebereiches liegt und somit kein Phasenausfall in der dritten Leitung 8 vorliegt.

Liegt hingegen ein Phasenausfall in der dritten Leitung 8 vor, so liegt eine Phasenverschiebung zwischen dem Strom in der ersten und zweiten Leitung 6,7 um die 180° vor. Eine Ermittlung des eine Phasenverschiebung zwischen dem Strom in der ersten und zweiten Leitung 6,7 charakterisierenden Wertes führt folglich zu einem anderen Wert als bei der Ermittlung während des Normalbetriebes. Wird dieser ermittelte Wert mit dem Wertebereich verglichen, so erkennt die Verarbeitungseinheit 10, dass der ermittelt Wert, welcher eine Phase zwischen der ersten und zweiten Leitung 6,7 von um die 180° charakterisiert, innerhalb des Wertebereiches liegt und somit ein Phasenausfall in der dritten Leitung 8 vorliegt. Der Wertebereich liegt vorzugsweise zwischen 150° und 210°.

Der Vorteil eines derartigen Sanftanlaufgerätes 1 besteht insbesondere darin, dass lediglich durch eine Überwachung der ersten und zweiten Leitung 6,7 ein Rückschluss auf einen Phasenausfall in der dritten Leitung 8 gewonnen werden kann. Das Gerät 1 kann kompakter ausgebildet werden und ferner können Kosten eingespart werden, da keine Messmittel bezüglich eines Phasenausfalls in der dritten Leitung 8 für die dritte Leitung 8 vorgesehen werden müssen.

Bei einem Phasenausfall in der ersten und zweiten Leitung 6,7 kann der Phasenausfall anhand der Höhe des Stromes und an der Unsymmetrie der beiden Ströme erkannt werden. Diese Werte können durch das Strommessmittel 9 ermittelt werden.

Als besonders vorteilhaft hat sich folgendes Verfahren zur Ermittlung eines Phasenausfalls in der dritten Phase 8 erwiesen. Mit Hilfe einer Analog-Digital-Abtastung wird bei eingeschalteten Drehstrommotor 2 wiederholt die Flussrichtung der beiden Ströme in der ersten und zweiten Leitung 6,7 ausgewertet. Jeder Strom wird z.B. alle 400ms abgetastet und das Vorzeichen des Abtastwertes ausgewertet. Hierfür gibt es zwei Zähler, die zu Beginn einer Stromperiode (der ersten oder zweiten Phase) auf Null gesetzt werden. Der eine Zähler zählt die Anzahl der gesamten Abtastwerte innerhalb einer Periode und der zweite Zähler wird während der Abtastung immer um 1 hochgezählt, wenn die beiden Ströme ein unterschiedliches Vorzeichen haben (entgegen gesetzte Flussrichtung). Am Ende einer Stromperiode (also alle 20ms bei 50Hz) werden diese Zähler ins Verhältnis gesetzt und ausgewertet. Dies erfolgt innerhalb der Verarbeitungseinheit 10. Bei einem Phasenausfall in der dritten Leitung 8 (der dritten Phase) liegt dieses Verhältnis innerhalb einer Periode zwischen 0 bis 10% (Überdeckung) oder zwischen 90 bis 100% (keine Überdeckung). Die beiden unterschiedlichen Prozentbereiche sind abhängig von dem Einbau des Stromsensors der ersten Leitung 6 gegenüber dem Stromsensor der zweiten Leitung 7, da der Einbau des Stromsensors die Flussrichtung und somit das Vorzeichen des Stromes der entsprechenden Leitung 6,7 bestimmt. Durch die gezielte Auswertung der beiden vorhandenen Stromkurven des Stroms in der ersten und zweiten Leitung 6,7 durch das Strommessmittel 9 und die Verarbeitungseinheit 10 kann auf einen dritten Stromsensor für die dritte Leitung 8 verzichtet werden. Ferner ist keine analoge Spannungsmessung in allen drei Leitungen 6,7,8 erforderlich. Es kann also ohne weiteres Hilfsmittel ein Phasenausfall in allen drei Phasen 6,7,8 mit Hilfe von nur zwei Stromsensoren (Stromwandlern) erkannt werden.

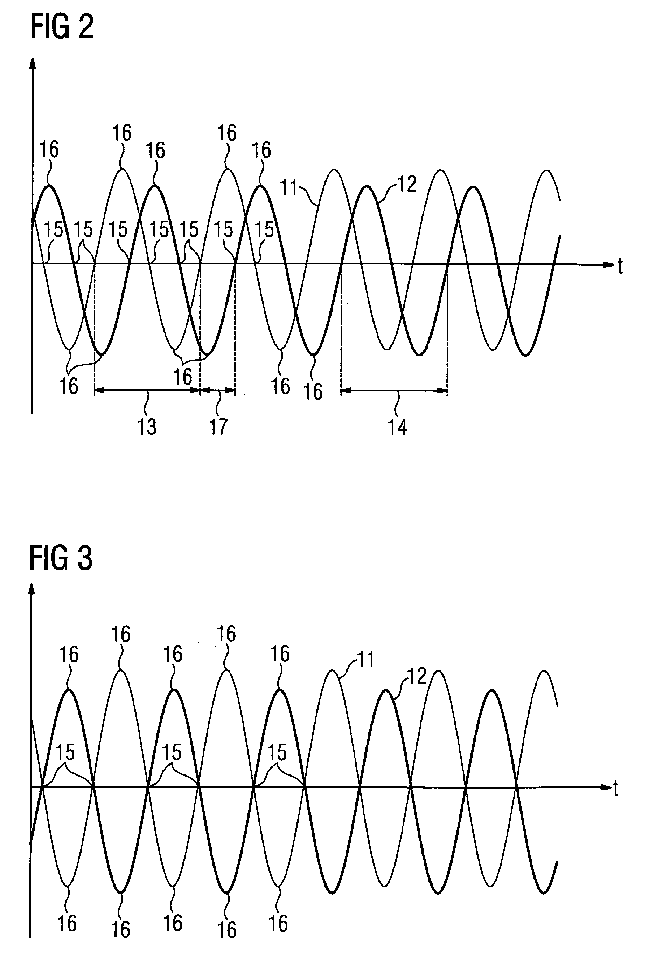

FIG 2 zeigt eine schematische Darstellung der Ströme in der ersten und zweiten Leitung, wenn alle drei Spannungen an den drei Phasen des elektrischen Geräts anliegen. An der ersten, zweiten und dritten Leitung liegt somit kein Phasenausfall vor. Über das abgebildete kartesische Koordinatensystem wird der zeitliche Verlauf des Stroms der ersten und zweiten Leitung über die Zeit visualisiert. Über die Abszissenachse wird der zeitliche Verlauf des Stroms (Ordinatenachse) dargestellt. Das Koordinatensystem zeigt die erste Stromkurve 11 der ersten Leitung sowie die zweite Stromkurve 12 der zweiten Leitung. Der Strom der ersten Leitung ist gegenüber dem Strom der zweiten Leitung um 120° phasenverschoben. Dies deutet bei einem dreiphasigen System auf einen ordnungsgemäßen Betrieb hin. Bei den Stromkurven 11,12 ist beispielhaft teilweise der Scheitelwert 16 sowie der Nulldurchgang 15 der jeweiligen Stromkurve 11,12 abgebildet. Das Zeitfenster 13 kennzeichnet eine Periode der ersten Stromkurve 11. Das Zeitfenster 14 kennzeichnet eine Periode der zweiten Stromkurve 12. Der Nulldurchgang 15 der ersten und zweiten Stromkurve 11,12 weist einen zeitlichen Versatz 17 auf. Die Phasenverschiebung zwischen der ersten Stromkurve 11 und der zweiten Stromkurve 12 spiegelt den Normalzustand des Sanftanlaufgerätes bei einer ordnungsgemäßen Energieversorgung des Drehstrommotors wieder. D.h. es liegt in keiner der Phasen des Sanftanlaufgerätes ein Phasenausfall vor.

FIG 3 zeigt eine schematische Darstellung der Ströme in der ersten und zweiten Leitung, wenn ein Phasenausfall in der dritten Leitung vorliegt. Im Vergleich zu FIG 2 weist nun die erste Stromkurve 11 gegenüber der zweiten Stromkurve 12 eine Phasenverschiebung von 180° auf. Anhand einer Analyse der Phasenverschiebung zwischen des Stroms in der ersten Leitung und der zweiten Leitung und somit eines Vergleichs der ersten Stromkurve 11 mit der zweiten Stromkurve 12 kann ein Rückschluss auf den Zustand der dritten Leitung (dritten Phase) gewonnen werden. Da die Phasenverschiebung zwischen der ersten Stromkurve 11 und der zweiten Stromkurve 12 nicht 120° sondern 180° beträgt, muss in der dritten Leitung ein Phasenausfall vorliegen. Da das Sanftanlaufgerät eine Analyse der Phasenverschiebung bzw. eines die Phasenverschiebung charakterisierenden Wertes mit einem Wertebereich, welcher einen Phasenausfall charakterisiert, durchführt, kann lediglich anhand der Analyse der ersten und zweiten Leitung des Sanftanlaufgerätes ein Rückschluss auf den ordnungsgemäßen Betrieb der dritten Phase gewonnen werden. Bei einem gleichzeitigen Ermitteln der Flussrichtung der ersten und zweien Stromkurve 11,12 und einem Vergleich der beiden Flussrichtungen ist die Flussrichtung bei 180° Phasenversatz bis auf den Nulldurchgang 15 immer entgegengesetzt ausgebildet. Folglich kann anhand einer Analyse der Flussrichtungen der ersten Stromkurve 11 gegenüber der Flussrichtung der zweiten Stromkurve 12 ein Rückschluss auf den Zustand der dritten Phase gewonnen werden. Durch eine prozentuale Auswertung der Differenzen der Flussrichtungen gegenüber den Ermittlungen kann beispielsweise ein Phasenausfall der dritten Leitung detektiert werden.

## Patentansprüche

1. Verfahren zur Ermittlung eines Phasenausfalls in einem elektrischen Gerät (1) zum Ansteuern oder Überwachen eines dreiphasigen Drehstrommotors (2), wobei das elektrische Gerät (1) eine erste, eine zweite und eine dritte Leitung (6,7,8) und ein Strommessmittel (9) umfasst und über das Strommessmittel (9) eine Strommessung des Stroms in der ersten und zweiten Leitung (6,7) erfolgen kann, wobei die Ermittlung des Phasenausfalls in der dritten Leitung (8) lediglich anhand einer Analyse der mittels des Strommessmittels (9) erfassten Ströme der ersten und zweiten Leitung (6,7) erfolgt, wobei die Analyse folgende Schritte umfasst:
a) gleichzeitiges Ermitteln der Flussrichtung des Stroms in der ersten und zweiten Leitung (6,7),
b) Ermitteln einer Anzahl von Differenzen, in welchen sich die unter Schritt a) ermittelte Flussrichtung der ersten Leitung (6) von der gleichzeitig ermittelten Flussrichtung der zweiten Leitung (7) unterscheidet oder ermitteln einer Anzahl von Übereinstimmungen, in welchen die unter Schritt a) ermittelte Flussrichtung der ersten Leitung (6) von der gleichzeitig ermittelten Flussrichtung der zweiten Leitung (7) übereinstimmt,
c) Ermitteln einer Anzahl der unter Schritt a) erfolgten Ermittlungen,
d) wenn unter Schritt b) die Anzahl von Differenzen ermittelt wurde, Ausgeben eines Signals, sofern innerhalb eines Zeitfensters das Verhältnis der Anzahl der Differenzen gegenüber der Anzahl der durchgeführten Ermittlungen in einem Wertebereich liegt, welcher einen Phasenausfall in der dritten Leitung (8) charakterisiert, oder wenn unter Schritt b) die Anzahl von Übereinstimmungen ermittelt wurde, Ausgeben eines Signals, sofern innerhalb eines Zeitfensters das Verhältnis der Anzahl der Übereinstimmungen gegenüber der Anzahl der durchgeführten Ermittlungen in einem Wertebereich liegt, welcher einen Phasenausfall in der dritten Leitung (8) charakterisiert.

2. Verfahren nach Anspruch 1, wobei der Wertebereich eine Phasenverschiebung zwischen der ersten und zweiten Leitung (7,8) von 150° bis 210° charakterisiert.

3. Verfahren nach einem der vorhergehenden Ansprüche, wobei
- wenn unter Schritt b) die Anzahl von Differenzen ermittelt wurde, der Wertebereich vorliegt, sofern innerhalb eines Zeitfensters das Verhältnis der Anzahl der Differenzen gegenüber der Anzahl der durchgeführten Ermittlungen zwischen 0% bis 10% oder 90% bis 100% liegt, oder
- wenn unter Schritt b) die Anzahl von Übereinstimmungen ermittelt wurde, der Wertebereich vorliegt, sofern innerhalb eines Zeitfensters das Verhältnis der Anzahl der Übereinstimmungen gegenüber der Anzahl der durchgeführten Ermittlungen zwischen 11% bis 89% liegt.

4. Verfahren nach Anspruch 3, wobei das elektrische Gerät (1) eine Verarbeitungseinheit (10) und ein Strommessmittel (9) umfasst, wobei der Schritt a) mittels des Strommessmittels (9) erfolgt und die Schritte b), c) und d) mittels der Verarbeitungseinheit (10) erfolgen.

5. Verfahren nach einem der Ansprüche 3 bis 4, wobei die unter Schritt b) ermittelte Anzahl sowie die Anzahl der ermittelten unter Schritt a) erfolgten Ermittlungen, vorzugsweise nach Ablauf des Zeitfensters, zurückgesetzt wird.

6. Verfahren nach einem der Ansprüche 3 bis 5, wobei die Verarbeitungseinheit (10) einen ersten und einen zweiten Zähler umfasst, wobei mit dem ersten Zähler die unter Schritt b) ermittelte Anzahl und mit dem zweiten Zähler die unter Schritt c) ermittelte Anzahl gezählt wird.

7. Verfahren nach einem der vorhergehenden Ansprüche, wobei das Zeitfenster mindestens eine Periodendauer des Stroms in der ersten oder zweiten Leitung (6,7) beträgt.

8. Elektrisches Gerät (1) zum Ansteuern oder Überwachen eines dreiphasigen Drehstrommotors (2), wobei das elektrische Gerät (1) eine erste, eine zweite und eine dritte Leitung (6,7,8), sowie eine Verarbeitungseinheit (10) und ein Strommessmittel (9) zum Ermitteln eines Stroms in der ersten und zweiten Leitung (6,7) umfasst, wobei mit dem Strommessmittel (9) gleichzeitig die Flussrichtung des Stroms in der ersten und zweiten Leitung (6,7) ermittelbar ist und mit der Verarbeitungseinheit (10) :
- eine Anzahl von Differenzen, in welchen sich die durch das Strommessmittel (9) ermittelte Flussrichtung der ersten Leitung (6) von der gleichzeitig ermittelten Flussrichtung der zweiten Leitung (7) unterscheidet, ermittelbar ist oder eine Anzahl von Übereinstimmungen, in welchen sich die durch das Strommessmittel ermittelte Flussrichtung der ersten Leitung (6) von der gleichzeitig ermittelten Flussrichtung der zweiten Leitung (7) übereinstimmen, ermittelbar ist,
- eine Anzahl der durch das Strommessmittel (9) erfolgten gleichzeitigen Ermittlungen der Flussrichtung des Stroms in der ersten und zweiten Leitung (6,7) ermittelbar ist, und
- ein Signal ausgebbar ist, sofern innerhalb eines Zeitfensters das Verhältnis der Anzahl der Differenzen oder Übereinstimmungen gegenüber der Anzahl der durchgeführten Ermittlungen in einem Wertebereich liegt, welcher einen Phasenausfall in der dritten Leitung (8) charakterisiert.

9. Elektrisches Gerät (1) nach Anspruch 8, wobei das elektrische Gerät (1) lediglich in der ersten und zweiten Leitung (6,7) eine Strömmessung durchführen kann.

10. Elektrisches Gerät (1) nach einem der Ansprüche 8 bis 9, wobei bei einer Ermittlung der Anzahl der Differenzen der Wertebereich vorliegt, sofern innerhalb des Zeitfensters das Verhältnis der Anzahl der Differenzen gegenüber der Anzahl der durchgeführten Ermittlungen zwischen 0% bis 10% oder 90% bis 100% liegt, oder bei einer Ermittlung der Anzahl der Übereinstimmungen der Wertebereich vorliegt, sofern innerhalb des Zeitfensters das Verhältnis der Anzahl der Übereinstimmungen gegenüber der Anzahl der durchgeführten Ermittlungen zwischen 11% bis 89% liegt.

11. Elektrisches Gerät (1) nach einem der Ansprüche 8 bis 10, wobei das elektrische Gerät (1) ein Sanftanlaufgerät (1) ist.

## Claims

1. Method for determining a phase failure in an electrical device (1) for controlling or monitoring a three-phase AC motor (2), wherein the electrical device (1) comprises a first, a second and a third conductor (6, 7, 8) and a current measuring means (9) and the current in the first and second conductor (6, 7) can be measured via the current measuring means (9), wherein the phase failure in the third conductor (8) is determined solely on the basis of an analysis of the currents of the first and second conductor (6, 7) measured by the current measuring means (9), wherein the analysis comprises the following steps:
a) Simultaneously determining the flow direction of the current in the first and second conductor (6, 7),
b) Determining a number of differences in which the flow direction of the first conductor (6) determined under step a) differs from the simultaneously determined flow direction of the second conductor (7) or determining a number of matches in which the flow direction of the first conductor (6) determined under step a) matches the simultaneously determined flow direction of the second conductor (7),
c) Determining the number of determinations performed under step a),
d) if the number of differences was determined under step b), outputting a signal if, within a time window, the ratio of the number of differences to the number of determinations performed lies within a range of values which characterises a phase failure in the third conductor (8) or, if the number of matches was determined under step b), outputting a signal if, within a time window, the ratio of the number of matches to the number of determinations performed lies within a range of values which characterises a phase failure in the third conductor (8).

2. Method according to claim 1, wherein the range of values characterises a phase shift of 150° to 210° between the first and second conductor (7, 8).

3. Method according to one of the preceding claims, wherein
- if the number of differences was determined under step b), the range of values is available if, within a time window, the ratio of the number of differences to the number of determinations performed lies between 0% and 10% or 90% and 100%
- if the number of matches was determined under step b), the range of values is available if, within a time window, the ratio of the number of differences to the number of determinations performed lies between 11% and 89%.

4. Method according to claim 3, wherein the electrical device (1) comprises a processing unit (10) and a current measuring means (9), wherein step a) is performed with the aid of the current measuring means (9) and steps b), c) and d) are performed by means of the processing unit (10).

5. Method according to one of claims 3 to 4, wherein the number determined under step b) and the number of determinations determined under step a) are reset, preferably after the time window has elapsed.

6. Method according to one of claims 3 to 5, wherein the processing unit (10) comprises a first and a second counter, the number determined under step b) being counted by means of the first counter and the number determined under step c) being counted by means of the second counter.

7. Method according to one of the preceding claims, wherein the time window is equal to at least one line period of the current in the first or second conductor (6, 7).

8. Electrical device (1) for controlling or monitoring a three-phase AC motor (2), wherein the electrical device (1) comprises a first, a second and a third conductor (6, 7, 8), as well as a processing unit (10) and a current measuring means (9) for determining a current in the first and second conductor (6, 7), wherein the flow direction of the current in the first and second conductor (6, 7) can be determined simultaneously with the aid of the current measuring means (9) and, using the processing unit (10):
- the number of differences, in which the flow direction of the first conductor (6) determined by the current measuring means (9) differs from the simultaneously determined flow direction of the second conductor (7), is able to be determined, or the number of matches, in which the flow direction of the first conductor (6) determined by the current measuring means matches the simultaneously determined flow direction of the second conductor (7), is able to be determined
- the number of simultaneous determinations of the flow direction of the current in the first and second conductor (6, 7) performed by the current measuring means (9) is able to be determined, and
- a signal is able to be output if, within a time window, the ratio of the number of differences or matches to the number of determinations performed lies in a range of values which characterises a phase failure in the third conductor (8).

9. Electrical device (1) according to claim 8, wherein the electrical device (1) can perform a current measurement solely in the first and second conductor (6, 7).

10. Electrical device (1) according to one of claims 8 to 9, wherein during a determination of the number of differences, the range of values is present if, within the time window, the ratio of the number of differences to the number of determinations performed lies between 0% and 10% or 90% and 100% or, during a determination of the number of matches, the range of values is present if, within a time window, the ratio of the number of matches in relation to the number of determinations performed lies between 11% and 89%.

11. Electrical device (1) according to one of claims 8 to 10, wherein the electrical device (1) is a soft starter (1).

## Revendications

1. Procédé de détermination d'une perte de phase dans un appareil (1) électrique pour la commande ou le contrôle d'un moteur (2) à courant triphasé, dans lequel l'appareil (1) électrique comprend une première, une deuxième et une troisième lignes (6, 7, 8) et un moyen (9) de mesure du courant et, par le moyen (9) de mesure du courant, une mesure du courant dans la première et dans la deuxième lignes (6, 7) peut être effectuée, la détermination de la perte de phase dans la troisième ligne (8) s'effectuant simplement au moyen d'une analyse des courants, détectés à l'aide du moyen (9) de mesure du courant, des première et deuxième lignes (6, 7), dans lequel l'analyse comprend les stades suivants :
a) détermination en même temps du sens du passage du courant dans la première et la deuxième lignes (6, 7),
b) détermination d'un nombre de différences, dans lesquelles le sens de passage déterminé dans le stade a) de la première ligne (6) se distingue du sens de passage déterminé en même temps de la deuxième ligne (7) ou détermination d'un nombre de coïncidences, dans lesquelles le sens de passade déterminé dans le stade a) de la première ligne (6) coïncide avec le sens de passage déterminé en même temps de la deuxième ligne (7),
c) détermination d'un nombre des déterminations effectuées dans le stade a),
d) si, dans le stade b), le nombre de différences a été déterminé, émission d'un signal pour autant que, dans un créneau temporel, le rapport du nombre de différences au nombre des déterminations effectuées se trouve dans une plage de valeur qui caractérise une perte de phases dans la troisième ligne (8) ou si, dans le stade b), le nombre de coïncidences a été déterminé, émission d'un signal pour autant que, dans un créneau temporel, le rapport du nombre des coïncidences au nombre des déterminations effectuées se trouve dans une plage de valeur qui caractérise une perte de phase dans la troisième ligne (8).

2. Procédé suivant la revendication 1, dans lequel la plage de valeur caractérise un déphasage entre la première et la deuxième lignes (7, 8) de 150° à 210°.

3. Procédé suivant l'une des revendications précédentes, dans lequel
- si, dans le stade b), on a déterminé le nombre de différences, on est dans la plage de valeur pour autant que, dans un créneau temporel, le rapport du nombre des différences au nombre des déterminations effectuées est compris entre 0% et 10% ou en 90% à 100%, ou
- si, dans le stade b), on a déterminé le nombre des coïncidences, on est dans la plage de valeur pour autant que, dans un créneau temporel, le rapport du nombre des coïncidences au nombre des déterminations effectuées est compris entre 11% et 89%.

4. Procédé suivant la revendication 3, dans lequel l'appareil (1) électrique comprend une unité (10) de traitement et un moyen (9) de mesure du courant, le stade a) s'effectuant à l'aide du moyen (9) de mesure du courant et les stades b), c) et d) s'effectuant à l'aide de l'unité (10) de traitement.

5. Procédé suivant l'une des revendications 3 à 4, dans lequel le nombre déterminé dans le stade b) ainsi que le nombre des déterminations effectuées déterminées dans le stade a) est remis à l'état initial, de préférence après l'expiration du créneau temporel.

6. Procédé suivant l'une des revendications 3 à 5, dans lequel l'unité (10) de traitement comprend un premier et un deuxième compteurs, dans lequel on compte par le premier compteur le nombre déterminé dans le stade b) et par le deuxième compteur le nombre déterminé dans le stade c).

7. Procédé suivant l'une quelconque des revendications précédentes, dans lequel le créneau temporel représente au moins une durée de période du courant dans la première ou la deuxième lignes (6, 7).

8. Appareil (1) électrique de commande ou de contrôle d'un moteur (2) à courant triphasé, l'appareil (1) électrique comprenant une première, une deuxième et une troisième lignes (6, 7, 8), ainsi qu'une unité (10) de traitement et un moyen (9) de mesure du courant pour mesurer un courant dans la première et la deuxième lignes (6, 7), le sens de passage du courant dans la première et dans la deuxième lignes (6, 7) pouvant être déterminé en même temps par le moyen (9) de mesure du courant et, par l'unité (10) de traitement :
- un nombre de différences, dans lesquelles le sens de passage déterminé par le moyen (9) de mesure du courant de la première ligne (6) se distingue du sens de passage déterminé en même temps de la deuxième ligne (7) peut être déterminé ou un nombre de coïncidences, dans lesquelles le sens de passage déterminé par le moyen de mesure du courant de la première ligne (6) coïncide avec le sens de passage déterminé en même temps de la deuxième ligne (7) peut être déterminé,
- un nombre des déterminations simultanées effectué par le moyen (9) de mesure du courant du sens de passage du courant dans la première et dans la deuxième lignes (6, 7) peut être déterminé, et
- un signal peut être émis pour autant que, dans un créneau temporel, le rapport du nombre des différences ou des coïncidences au nombre des déterminations effectuées se trouve dans une plage de valeur qui caractérise une perte de phase dans la troisième ligne (8).

9. Appareil (1) électrique suivant la revendication 8, dans lequel l'appareil (1) électrique peut effectuer une mesure du courant seulement dans la première et dans la deuxième lignes (6, 7).

10. Appareil (1) électrique suivant l'une des revendications 8 à 9, dans lequel, lors d'une détermination du nombre des différences, on se trouve dans la plage de valeur pour autant que, dans le créneau temporel, le rapport du nombre de différences au nombre des déterminations effectuée est compris entre 0% et 10% ou entre 90% à 100% ou lors d'une détermination du nombre des coïncidences, on se trouve dans la plage de valeur pour autant que, dans le créneau temporel, le rapport du nombre des coïncidences au nombre des déterminations effectuées est compris entre 11% à 89%.

11. Appareil (1) électrique suivant les revendications 8 à 10, dans lequel l'appareil (1) électrique est un appareil (1) à démarrage en douceur.
